# EUROPEAN PATENT APPLICATION

(11) **EP 3 985 722 A1**
(43) Date of publication of application: **20.04.2022**
(21) Application number: 21202233.9
(22) Date of filing: 12.10.2021
(51) Int. Cl.: H01L 25/075, H01L 25/16, H01L 27/15, H01L 33/60, H01L 33/62, H01L 33/50

(54) **DISPLAY DEVICE AND METHOD OF MANUFACTURING THE SAME**

(30) Priority: 13.10.2020 KR 20200131685
(71) Applicant: Samsung Display Co., Ltd., Yongin-si, Gyeonggi-Do 17113 (KR)
(72) Inventor: JEON, Hyung Il, Seoul (KR); KIM, Min Woo, Hwaseong-si (KR); SONG, Dae Ho, Hwaseong-si (KR); YANG, Byung Choon, Seoul (KR); CHOI, Jin Woo, Seoul (KR)
(74) Representative: Taor, Simon Edward William

(57) **Abstract**

A display device includes pixel electrodes disposed on a substrate, light-emitting diode elements disposed on the pixel electrodes, an insulating film disposed on at least a side of each of the pixel electrodes and disposed on at least a side of each of the light-emitting diode elements, partition walls disposed on the insulating film, and a common electrode disposed on the partition walls and the light-emitting diode elements.

## Description

### BACKGROUND

### 1. Technical Field

The disclosure relates to a display device and a method of manufacturing the same.

### 2. Description of the Related Art

As the information society has developed, the demand for display devices for displaying images has intensified. Here, the display devices may be flat panel display devices such as a liquid crystal display (LCD) device, a field emission display (FED) device, or a light-emitting display device, and the light-emitting display device may be one of an organic light-emitting display device including organic light-emitting diodes (OLEDs) as light-emitting elements, an inorganic light-emitting display device including inorganic semiconductor elements as light-emitting elements, and a micro-light-emitting diode (mLED) display device including mLEDs as light-emitting elements.

Head--mounted displays (HMDs) equipped with light-emitting display devices have been developed. HMDs are devices that can be worn like glasses or a helmet and forms a focus at a close distance from the eyes of a user for providing virtual reality (VR) or augmented reality (AR).

A high-resolution mLED display panel including mLEDs can be applied to an HMD. To prevent light emitted from one mLED from being mixed with light emitted from other neighboring mLEDs, partition walls may be provided between the mLEDs. However, as the integration density of the mLEDs is high, the partition walls need to be thin and may thus be difficult to fabricate.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

Embodiments provide a display device capable of simplifying the fabrication of partition walls between light-emitting diodes (LEDs).

Embodiments also provide a method of manufacturing a display device capable of simplifying the fabrication of partition walls between LEDs.

Additional features of embodiments will be set forth in the description which follows, and in part may be apparent from the description, or may be learned by practice of an embodiment or embodiments herein.

According to an embodiment, a display device may include pixel electrodes disposed on a substrate; light-emitting diode elements disposed on the pixel electrodes; an insulating film disposed on at least a side of each of the pixel electrodes and disposed on at least a side of each of the light-emitting diode elements; partition walls disposed on the insulating film; and a common electrode disposed on the partition walls and the light-emitting diode elements.

Each of the light-emitting diode elements may include a first electrode, a light-emitting layer, and a second electrode, which may be sequentially stacked in a thickness direction of the substrate.

The first electrode of each of the light-emitting diode elements may electrically contact one of the pixel electrodes. The second electrode of each of the light-emitting diode elements may electrically contact the common electrode.

The common electrode may include a transparent conductive material.

The partition walls may include a conductive material.

The partition walls may include an opaque metallic material.

The partition walls may be electrically connected to the common electrode.

The display device may further include a black matrix disposed on the common electrode and overlapping the partition walls in a thickness direction of the substrate.

The partition walls may include a photosensitive light blocking resin.

A height of a partition wall of the partition walls may be greater than a height of a light-emitting diode element of the light-emitting diode elements.

The common electrode may be disposed on at least a side surface of each of the partition walls.

The display device may further include a first wavelength conversion layer overlapping a light-emitting diode element among the light-emitting diode elements in a first emission area in a thickness direction of the substrate; a second wavelength conversion layer overlapping a light-emitting diode element among the light-emitting diode elements in a second emission area in the thickness direction of the substrate; and a transparent insulating film overlapping a light-emitting diode element among the light-emitting diode elements in a third emission area in the thickness direction of the substrate.

The first wavelength conversion layer, the second wavelength conversion layer, and the transparent insulating film may be disposed on the common electrode.

The first wavelength conversion layer, the second wavelength conversion layer, and the transparent insulating film may be disposed between the partition walls.

The display device may further include a first color filter disposed on the first wavelength conversion layer; a second color filter disposed on the second wavelength conversion layer; and a third color filter disposed on the transparent insulating film.

The common electrode may be electrically connected to a common connecting electrode. The common connecting electrode may be disposed on the substrate through a common electrode connector through the insulating film.

According to an embodiment, a method of manufacturing a display device may include bonding pixel electrodes of a first substrate and light-emitting diode elements of a second substrate; separating the light-emitting diode elements from the second substrate; forming an insulating film on the light-emitting diode elements; forming a partition wall material on the insulating film forming partition walls by planarizing the partition wall material by polishing to expose first electrodes of the light-emitting diode elements; and forming a common electrode on the partition walls and the light-emitting diode elements.

Each of the light-emitting diode elements may include a first electrode, a light-emitting layer, and a second electrode, which may be sequentially stacked in a thickness direction of the substrate.

According to an embodiment, a method of manufacturing a display device may include bonding pixel electrodes of a first substrate and light-emitting diode elements of a second substrate; separating the light-emitting diode elements from the second substrate; forming an insulating film on the light-emitting diode elements; forming a partition wall material on the insulating film; forming partition walls by photolithography to expose first electrodes of the light-emitting diode elements; and forming a common electrode on the partition walls and the light-emitting diode elements.

The method may further include forming a first wavelength conversion layer on a first light-emitting diode element among the light-emitting diode elements; forming a second wavelength conversion layer on a second light-emitting diode element among the light-emitting diode elements; forming a transparent insulating film on a third light-emitting diode element among the light-emitting diode elements; forming a first color filter on the first wavelength conversion layer; forming a second color filter on the second wavelength conversion layer; and forming a third color filter on the transparent insulating film.

According to an embodiment, as LED elements are vertical LED elements that extend in a third direction (or a Z-axis direction), a partition wall material can be formed between the LED elements, and partition walls can be formed via polishing such as chemical mechanical polishing (CMP) to expose the top surfaces of the LED elements. Thus, since the partition walls do not need to be thinned down via, for example, photolithography, the fabrication of the partition walls between the LED elements can be facilitated.

According to an embodiment, as the partition walls include a metallic material with high reflectance, light emitted sideways from the LED elements can be output to the tops of the LED elements. Thus, the emission efficiency of the LED elements can be improved due to the presence of the partition walls.

According to an embodiment, as a common electrode is disposed on the partition walls, the common electrode can be electrically connected to the partition walls. Thus, the resistance of the common electrode can be lowered, and as a result, a common voltage applied to the common electrode can be prevented from decreasing due to the resistance of the common electrode.

According to an embodiment, wavelength conversion layers can be arranged or disposed in the spaces on the LED elements, between the partition walls, by forming the partition walls to be higher than the LED elements. Thus, the image quality of a display device can be improved.

According to an aspect, there is provided a display device as set out in claim 1. Additional features are set out in claims 2 to 11.

According to an aspect, there is provided a method as set out in claim 12.

Other features and embodiments may be apparent from the following detailed description, the drawings, and the claims.

It is to be understood that both the foregoing description and the following detailed description are not to be construed as limiting of an embodiment or embodiments as described or claimed herein.

### BRIEF DESCRIPTION OF THE DRAWINGS

The accompanying drawings, which are included to provide a further understanding of the disclosure, illustrate embodiments in which:
FIG. 1 is a perspective view of a display device according to an embodiment;
FIG. 2 is a layout view illustrating emission areas of a light-emitting element layer of the display device of FIG. 1;
FIG. 3 is a schematic cross-sectional view taken along lines I-I' and II-II' of FIG. 2;
FIG. 4 is a schematic cross-sectional view illustrating light-emitting elements of FIG. 3;
FIG. 5 is a schematic cross-sectional view, taken along line I-I' of FIG. 2, of a display device according to an embodiment;
FIG. 6 is a schematic cross-sectional view, taken along line I-I' of FIG. 2, of a display device according to an embodiment;
FIG. 7 is a flowchart illustrating a method of manufacturing a display device according to an embodiment;
FIGS. 8 through 14 are schematic cross-sectional views illustrating the method of manufacturing a display device according to an embodiment;
FIG. 15 is a flowchart illustrating a method of manufacturing a display device according to an embodiment;
FIGS. 16 through 20 are schematic cross-sectional views illustrating the method of manufacturing a display device according to an embodiment; and
FIG. 21 is a perspective view of a virtual reality (VR) device including a display device according to an embodiment.

### DETAILED DESCRIPTION OF THE EMBODIMENTS

The embodiments will now be described more fully hereinafter with reference to the accompanying drawings. The embodiments may, however, be provided in different forms and should not be construed as limiting. The same reference numbers indicate the same components throughout the disclosure. In the accompanying figures, the thickness of layers and regions may be exaggerated for clarity.

As used herein, the singular forms, "a," "an," and "the" are intended to include the plural forms as well, unless the context clearly indicates otherwise.

Some of the parts which may not be associated with the description may not be provided in order to describe embodiments of the disclosure.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below a second object, and vice versa. Additionally, the term "overlap" may include layer, stack, face or facing, extending over, covering, or partly covering or any other suitable term as would be appreciated and understood by those of ordinary skill in the art. The expression "not overlap" may include "apart from" or "set aside from" or "offset from" and any other suitable equivalents as would be appreciated and understood by those of ordinary skill in the art. The terms "face" and "facing" mean that a first object may directly or indirectly oppose a second object. In a case in which a third object intervenes between a first and second object, the first and second objects may be understood as being indirectly opposed to one another, although still facing each other.

The spatially relative terms "below", "beneath", "lower", "above", "upper", or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" to another element, the element may be "directly connected" to another element, or "electrically connected" to another element with one or more intervening elements interposed therebetween. It will be further understood that when the terms "comprises," "comprising," "has", "have", "having", "includes" and/or "including" and variations thereof are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of' is intended to include the meaning of "at least one selected from the group of' for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

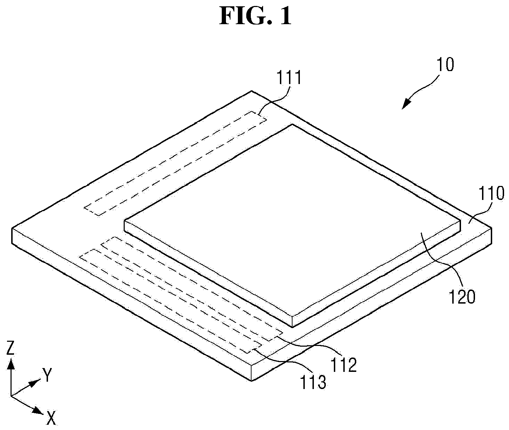

FIG. 1 is a perspective view of a display device according to an embodiment.

Referring to FIG. 1, a display device 10 may include a semiconductor circuit unit 110 and a light-emitting element layer 120.

The display device 10 is illustrated in FIG. 1 as being a micro-light-emitting diode (mLED) display device including mLED elements, but embodiments of the disclosure are not limited thereto. The display device 10 will hereinafter be described as being an LED-on-silicon (LEDoS) in which LED elements may be arranged or disposed on the semiconductor circuit unit 110 obtained by a semiconductor process, but embodiments of the disclosure are not limited thereto.

The semiconductor circuit unit 110 may be a silicon wafer substrate formed by a semiconductor process. The semiconductor circuit unit 110 is illustrated as having a substantially rectangular shape in a plan view, but embodiments of the disclosure are not limited thereto. As an example, the semiconductor circuit unit 110 may have various other shapes such as a substantially non-tetragonal polygonal shape, a substantially circular shape, a substantially elliptical shape, or an amorphous shape in a plan view.

The semiconductor circuit unit 110 may include scan lines, data lines, pixel circuit units, a scan driver 111, a data driver 112, and a pad portion 113.

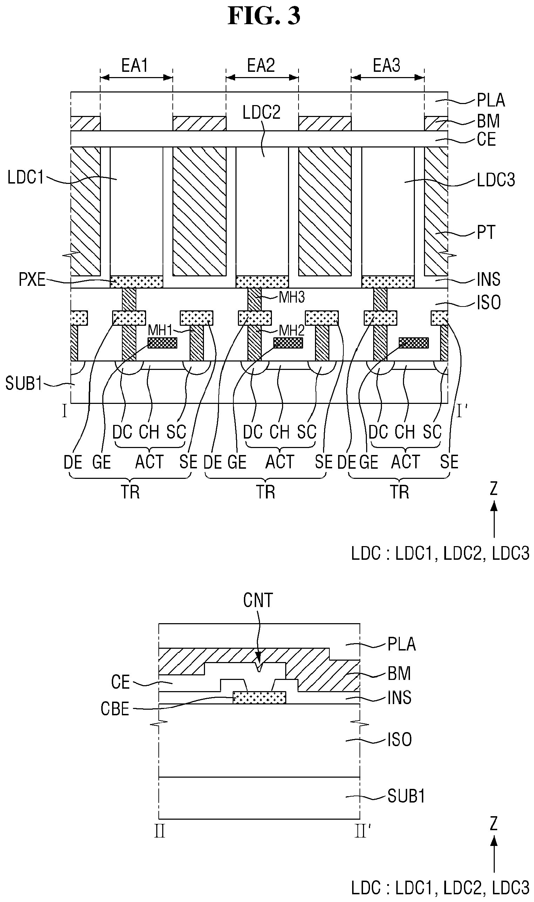

The scan lines may extend in a first direction (for example, X-axis direction), and the data lines may extend in a second direction (for example, Y-axis direction). The scan lines and the data lines may be electrically connected to the pixel circuit units. Each of the pixel circuit units may include at least one transistor electrically connected to one of the scan lines and one of the data lines. In response to scan signals being applied to the scan lines, the pixel circuit units may receive data voltages from the data lines. The pixel circuit units may apply a driving current or a driving voltage to LED elements so that the LED elements can emit light of a predetermined brightness. The scan lines, the data lines, and the pixel circuit units of the semiconductor circuit units 110 will be described later with reference to FIG. 3.

The scan driver 111 may receive scan timing signals from the data driver 112 or the pad portion 113. The scan driver 111 may generate scan signals in accordance with the scan timing signals and may output the scan signals to the scan lines. The scan driver 111 may include a plurality of transistors.

The data driver 112 may receive digital video data from the pad portion 113. The data driver 112 may convert digital video data into analog data voltages and may output the analog data voltages to the data lines. The data driver 112 may include a plurality of transistors.

The pad portion 113 may include pads for electrical connection to an external circuit board. The pads may be electrically connected to the scan driver 111 and the data driver 112.

The circuit board may be electrically connected to the pads of the pad portion 113 via a low-resistance, high-reliability material such as an anisotropic conductive film or a self-assembly anisotropic conductive paste (SAP). As an example, the circuit board may be electrically connected to the pads of the pad portion 113 via ultrasonic bonding. The circuit board may be a flexible printed circuit board (FPCB), a printed circuit board (PCB), a flexible printed circuit (FPC), or a flexible film such as a chip-on-film (COF).

The light-emitting element layer 120 may be disposed on the semiconductor circuit unit 110. The light-emitting element layer 120 may have a smaller size than the semiconductor circuit unit 110. The light-emitting element layer 120 may overlap the pixel circuit units of the semiconductor pixel circuit 110 in a third direction (or a Z-axis direction). The light-emitting element layer 120 may not overlap the scan driver 111, the data driver 112, and the pad portion 113 of the semiconductor circuit unit 110 in the third direction (for example, Z-axis direction).

The light-emitting element layer 120 may include emission areas in which LED elements are disposed to emit light. The emission areas may include LED elements. The LED elements of the emission areas may be electrically connected to the transistors of the pixel circuit units of the semiconductor circuit unit 110. The LED elements of the emission areas may receive a driving voltage or a driving current from the pixel circuit units of the semiconductor circuit unit 110. The LED elements of the emission areas may emit light of a predetermined brightness in accordance with the driving voltage or the driving current.

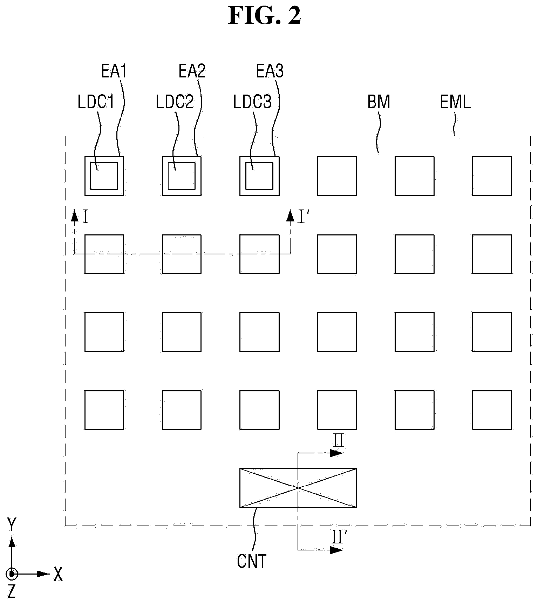

FIG. 2 is a layout view illustrating the emission areas of the light-emitting element layer of the display device of FIG. 1.

Referring to FIG. 2, the light-emitting element layer EML may include first emission areas EA1, second emission areas EA2, third emission areas EA3, and a common electrode connector CNT.

The first emission areas EA1 may refer to areas that emit first light. First LED elements LDC1, which emit the first light, may be disposed in the first emission areas EA1. The first light may be light of a red wavelength range. The red wavelength range may be in a range of about 600 nm to about 750 nm, but embodiments of the disclosure are not limited thereto.

The second emission areas EA2 may refer to areas that emit second light. Second LED elements LDC2, which emit the second light, may be disposed in the second emission areas EA2. The second light may be light of a green wavelength range. The green wavelength range may be in a range of about 480 nm to about 560 nm, but embodiments of the disclosure are not limited thereto.

The third emission areas EA3 may refer to areas that emit third light. Third LED elements LDC3, which emit the third light, may be disposed in the third emission areas EA3. The third light may be light of a blue wavelength range. The blue wavelength range may be in a range of about 370 nm to about 460 nm, but embodiments of the disclosure are not limited thereto.

The first emission areas EA1 may be arranged or located in the second direction (for example, Y-axis direction). The second emission areas EA2 may be arranged or located in the second direction (for example, Y-axis direction). The third emission areas EA3 may be arranged or located in the second direction (for example, Y-axis direction).

The first emission areas EA1, the second emission areas EA2, and the third emission areas EA3 may be alternately arranged or located in the first direction (for example, X-axis direction). For example, the first emission areas EA1, the second emission areas EA2, and the third emission areas EA3 may be sequentially arranged or located in the order of first, second, and third emission areas EA1, EA2, and EA3 in the first direction (for example, X-axis direction).

Pixels may be defined by arrays, in the first direction (for example, X-axis direction), of first, second, and third emission areas EA1, EA2, and EA3, but embodiments of the disclosure are not limited thereto. The pixels may be defined as minimum emission units displaying white gradation.

The common electrode connector CNT may be a contact hole that electrically connects a common electrode and a common connecting electrode. The common electrode may receive a common voltage via the common connecting electrode that may be electrically connected to the pad portion 113.

The first emission areas EA1, the second emission areas EA2, and the third emission areas EA3 may overlap the pixel circuit units in the third direction (for example, Z-axis direction), but the common electrode connector CNT may not overlap the pixel circuit units in the third direction (for example, Z-axis direction).

FIG. 3 is a schematic cross-sectional view taken along lines I-I' and II-II' of FIG. 2.

Referring to FIG. 3, the pixel circuit unit 110 may include a first substrate SUB1 and the pixel circuit unit 110, may include one or more transistors TR and one or more pixel electrodes PXE. The transistors TR may include active layers ACT, gate electrodes GE, source electrodes SE, and drain electrodes DE.

The first substrate SUB 1 may be a p- or n-type silicon substrate.

The active layers ACT, which include channel regions CH, source connectors SC, and drain connectors DC, may be disposed on the top surface of the first substrate SUB1. The channel regions CH may be semiconductor regions, and the source connectors SC and the drain connectors DC may be conductor regions. The source connectors SC and the drain connectors DC may be regions doped with impurities.

An insulating layer ISO may be disposed on the first substrate SUB1. The gate electrodes GE, the source electrodes SE, and the drain electrodes DE may be disposed in the insulating layer ISO.

The gate electrodes GE may overlap the channel regions CH in the third direction (for example, Z-axis direction), the source electrodes SE may overlap the source connectors SC in the third direction (for example, Z-axis direction), and the drain electrodes DE may overlap the drain connectors DC in the third direction (for example, Z-axis direction). The source electrodes SE may be electrically connected to the source connectors SC through first metal holes MH1. The first metal holes MH1 may refer to regions from which the insulating layer ISO is removed between the source electrodes SE and the source connectors SC and which are filled with a metal. The drain electrodes DE may be electrically connected to the drain connectors DC through second metal holes MH2. The second metal holes MH2 may refer to regions from which the insulating layer ISO is removed between the drain electrodes DE and the source connectors SC and which are filled with a metal.

The pixel electrodes PXE may be disposed on the insulating layer ISO. The pixel electrodes PXE may overlap the drain electrodes DE in the third direction (for example, Z-axis direction). The pixel electrodes PXE may be electrically connected to the drain electrodes DE through third metal holes MH3. The third metal holes MH3 may refer to regions from which the insulating layer ISO may be removed between the pixel electrodes PXE and the drain electrodes DE and which may be filled with a metal. The pixel electrodes PXE may include a metallic material with high reflectance. For example, the pixel electrodes PXE may include an opaque metallic material such as molybdenum (Mo), aluminum (Al), chromium (Cr), gold (Au), titanium (Ti), nickel (Ni), neodymium (Nd), or copper (Cu). As an example, the pixel electrodes PXE may include a metallic material with high reflectance such as a stack of Al and Ti (for example, Ti/Al/Ti), a stack of Al and indium tin oxide (ITO) (for example, ITO/A1/ITO), a silver (Ag)-palladium (Pd)-copper (Cu) (APC) alloy, or a stack of an APC alloy and ITO (for example, ITO/APC/ITO).

LED elements LDC may be disposed on the pixel electrodes PXE to correspond one-to-one to the pixel electrodes PXE. The LED elements LDC may include first, second, and third LED elements LDC1, LDC2, and LDC3.

The first, second, and third LED elements LDC1, LDC2, and LDC3 may be vertical LED elements that extend in the third direction (for example, Z-axis direction). For example, the first, second, and third LED elements LDC1, LDC2, and LDC3 may extend longer in the third direction (for example, Z-axis direction) than in a horizontal direction. Here, the horizontal direction may refer to the first direction (for example, X-axis direction) or the second direction (for example, Y-axis direction).

The first, second, and third LED elements LDC1, LDC2, and LDC3 may be mLED elements. For example, the first, second, and third LED elements LDC1, LDC2, and LDC3 may have a length of about 10 *µ*m in the third direction (for example, Z-axis direction). For example, the first, second, and third LED elements LDC1, LDC2, and LDC3 may have a length of about 5 *µ*m in the horizontal direction.

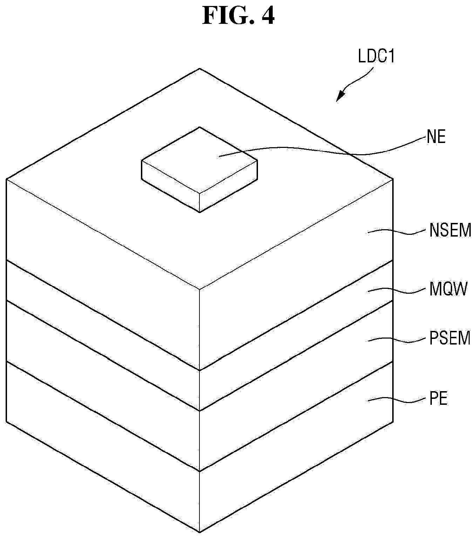

The first LED element LDC1 may include a p-type electrode PE, a p-type gallium nitride (GaN) semiconductor layer PSEM, an active layer MQW, an n-type GaN semiconductor layer NSEM, and an n-type electrode NE, as illustrated in FIG. 4. The p-type electrode PE may be a first electrode, and the n-type electrode NE may be a second electrode.

The p-type electrode PE, the p-type GaN semiconductor layer PSEM, the active layer MQW, the n-type GaN semiconductor layer NSEM, and the n-type electrode NE may be sequentially stacked each other in the third direction (for example, Z-axis direction).

The p-type electrode PE, which is a high-reflectance electrode, may include Ag or an Ag alloy. The p-type electrode PE reflects light emitted by the active layer MQW toward the n-type GaN semiconductor layer NSEM. The p-type electrode PE may be electrically connected to one of the pixel electrodes PXE.

The p-type GaN semiconductor layer PSEM may be disposed on the p-type electrode PE. The p-type GaN semiconductor layer PSEM may be a semiconductor layer obtained by doping a GaN layer with p-type impurities.

The active layer MQW may be disposed on the p-type GaN semiconductor layer PSEM. In the active layer MQW, electrons from the n-type GaN semiconductor layer NSEM and holes from the p-type GaN semiconductor layer PSEM combine together. The active layer MQW may emit light of a wavelength corresponding to a bandgap difference determined by the material of the active layer MQW. The active layer MQW may be a double heterostructure, a single quantum well, or a multi-quantum well. For example, if the first LED element LDC1 emits blue or green light, the multi-quantum well may have an InGaN/GaN structure. In another example, if the first LED element LDC1 emits ultraviolet (UV) light, the multi-quantum well may have an AlGaN/InGaN structure.

The n-type GaN semiconductor layer NSEM may be disposed on the active layer MQW. The n-type GaN semiconductor layer NSEM may be a semiconductor layer obtained by doping a GaN layer with n-type impurities.

The n-type electrode NE may be disposed on the n-type GaN semiconductor layer NSEM. The n-type electrode NE may be in ohmic contact with the n-type GaN semiconductor layer NSEM. The n-type electrode NE may include Ni, Cr, or Au. For example, the n-type electrode NE may have a Ti- or Cr-based multilayer structure such as Ti/Al, Ti/Al/Ni/Au, Cr/Al, or Cr/Al/Ni/Au. The n-type electrode NE may be electrically connected to a common electrode CE.

The second and third LED elements LDC2 and LDC3 may be formed to have substantially the same structure as the first LED element LDC1 of FIG. 4.

An insulating film INS may be disposed on the LED elements LDC. The insulating film INS may be disposed on side surfaces of each of the first, second, and third LED elements LDC1, LDC2, and LDC3. The insulating film INS may also be disposed on side surfaces of each of the pixel electrodes PXE.

The insulating film INS may be formed as an inorganic film such as a silicon nitride layer, a silicon oxynitride layer, a silicon oxide layer, a titanium oxide layer, or an aluminum oxide layer. As an example, the insulating film INS may be formed as an organic film including an acrylic resin, an epoxy resin, a phenolic resin, a polyamide resin, or a polyimide resin.

Partition walls PT may be disposed between the LED elements LDC. The partition walls PT may be disposed between the first and second LED elements LDC1 and LDC2, between the second and third LED elements LDC2 and LDC3, and between the first and third LED elements LDC1 and LDC3. The partition walls PT may be disposed on the insulating film INS. The bottom surface and the side surfaces of each of the partition walls PT may be in contact with the insulating film INS.

The partition walls PT may include a conductive material. The partition walls PT may include a metallic material with high reflectance. For example, the partition walls PT may include an opaque metallic material such as Mo, Al, Cr, Au, Ti, Ni, Nd, or Cu. In this example, light emitted from the LED elements LDC may be reflected by the pixel electrodes PXE and the partition walls PT and may thus be output to the tops of the light-emitting elements LDC. Accordingly, the emission efficiency of the LED elements LDC can be improved due to the presence of the partition walls PT.

The top surfaces of the LED elements LDC, the top surface of the insulating film INS, and the top surfaces of the partition walls PT may be planarized by a polishing process such as chemical mechanical polishing (CMP).

The common electrode CE may be disposed on the top surfaces of the LED elements LDC, the top surface of the insulating film INS, and the top surfaces of the partition walls PT. The common electrode CE may include a transparent conductive material. For example, the common electrode CE may include a transparent conductive oxide (TCO) such as ITO or indium zinc oxide (IZO).

The common electrode CE may be electrically connected to the partition walls PT. Thus, the resistance of the common electrode CE can be lowered, and as a result, the common voltage applied to the common electrode CE can be prevented from decreasing due to the resistance of the common electrode CE.

The partition walls PT may not be disposed on the common electrode connector CNT. Thus, the common electrode CE may be electrically connected to a common connecting electrode CBE through the common electrode connector CNT, which penetrates the insulating film INS. The common connecting electrode CBE may be disposed on the insulating layer ISO. The common connecting electrode CBE may be disposed in the same layer as, and may include the same material or similar material as, the pixel electrodes PXE. The common connecting electrode CBE may be electrically connected to the pad portion 113 through a metal hole by electrodes or wires disposed in the insulating layer ISO. Thus, the common connecting electrode CBE may receive the common voltage from an external circuit board.

A black matrix BM may be disposed on the common electrode CE. The black matrix BM may overlap the partition walls PT in the third direction (for example, Z-axis direction). The black matrix BM may be formed of a photosensitive resin blocking light. For example, the black matrix BM may include an inorganic black pigment such as carbon black or an organic black pigment. Due to the presence of the black matrix BM, light emitted from adjacent LED elements LDC can be prevented from being mixed together.

A planarization film PLA may be disposed on the common electrode CE and the black matrix BM. The planarization film PLA may be formed as an organic film including an acrylic resin, an epoxy resin, a phenolic resin, a polyamide resin, or a polyimide resin.

As illustrated in FIG. 3, as the LED elements LDC are vertical LED elements that extend in the third direction (for example, Z-axis direction), the partition walls PT may be formed in the gaps between the LED elements LDC. Thus, the fabrication of the partition walls PT can be facilitated.

Also, as the partition walls PT include a metallic material with high reflectance, light emitted sideways from the LED elements LDC can be reflected by the partition walls PT and can thus be output to the tops of the LED elements LDC. Thus, the emission efficiency of the LED elements LDC can be improved due to the presence of the partition walls PT.

Also, as the common electrode CE is disposed on the partition walls PT, the common electrode CE can be electrically connected to the partition walls PT. Thus, the resistance of the common electrode CE can be lowered, and as a result, the common voltage applied to the common electrode CE can be prevented from decreasing due to the resistance of the common electrode CE.

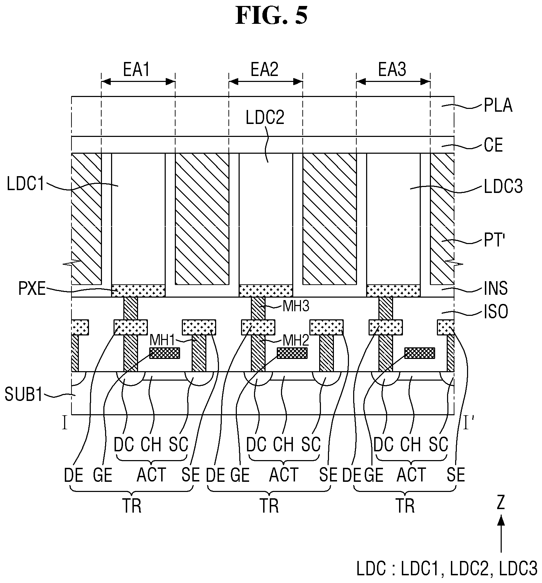

FIG. 5 is a schematic cross-sectional view, taken along line I-I' of FIG. 2, of a display device according to an embodiment.

The embodiment of FIG. 5 may differ from the embodiment of FIG. 3 in that partition walls PT' may be formed of a photosensitive resin blocking light, instead of a metallic material with high reflectance, and as a result, a black matrix BM may not be provided. The embodiment of FIG. 5 will hereinafter be described, focusing on the differences with the embodiment of FIG. 3.

Referring to FIG. 5, the partition walls PT' may include an inorganic black pigment such as carbon black or an organic black pigment. Due to the presence of the partition walls PT', light emitted from adjacent LED elements LDC can be prevented from being mixed together. The black matrix BM of FIG. 3 performs substantially the same functions as the partition walls PT' and may thus not be provided in the display device of FIG. 5.

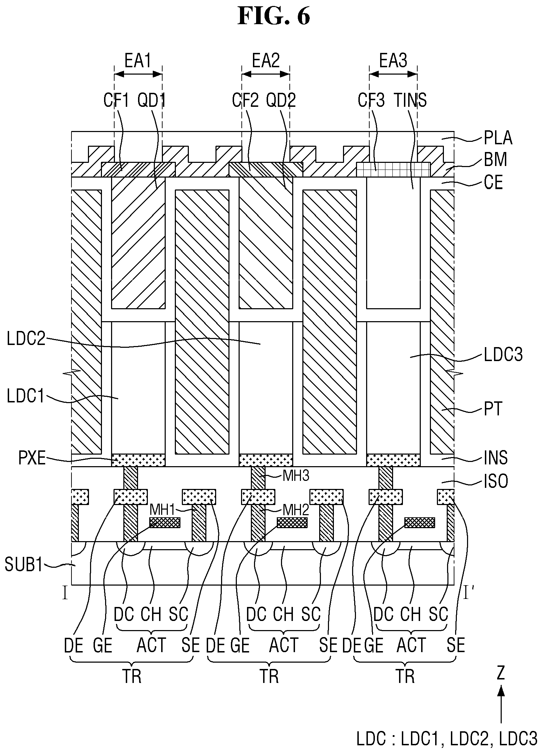

FIG. 6 is a schematic cross-sectional view, taken along line I-I' of FIG. 2, of a display device according to an embodiment.

The embodiment of FIG. 6 may differ from the embodiment of FIG. 3 in that first and second wavelength conversion layers QD1 and QD2 may be disposed on LED elements LDC. The embodiment of FIG. 6 will hereinafter be described, focusing on the differences with the embodiment of FIG. 3.

Referring to FIG. 6, the height of partition walls PT may be greater than the height of LED elements LDC. The height of the partition walls PT may be greater than the heights of first, second, and third LED elements LDC1, LDC2, and LDC3. The height of the partition walls PT may be defined as the maximum length, in a third direction (or a Z-axis direction), of the partition walls PT. The height of the first LED element LDC1 may be defined as the maximum length, in the third direction (for example, Z-axis direction), of the first LED element LDC 1. The height of the second LED element LDC2 may be defined as the maximum length, in the third direction (for example, Z-axis direction), of the second LED element LDC2. The height of the third LED element LDC3 may be defined as the maximum length, in the third direction (for example, Z-axis direction), of the third LED element LDC3.

A common electrode CE may be disposed on the top surfaces of the LED elements LDC, the top surface of an insulating film INS, the top surfaces of the partition walls PT, and parts of the side surfaces of each of the partition walls PT. As the height of the partition walls PT is greater than the height of the LED elements LDC, the common electrode CE may be disposed on the side surfaces of parts of the partition walls PT that protrude beyond the LED elements LDC.

As the height of the partition walls PT is greater than the height of the LED elements LDC, there may exist spaces on the LED elements LDC, between the partition walls PT. The spaces may have a substantially hole-like shape.

A first wavelength conversion layer QD1 may be disposed in the space on the first LED element LDC1. The first wavelength conversion layer QD1 may overlap the first LED element LDC1 in the third direction (for example, Z-axis direction). A second wavelength conversion layer QD2 may be disposed in the space on the second LED element LDC2. The second wavelength conversion layer QD2 may overlap the second LED element LDC2 in the third direction (for example, Z-axis direction). A transparent insulating film TINS may be disposed in the space on the third LED element LDC3. The transparent insulating film TINS may overlap the third LED element LDC3 in the third direction (for example, Z-axis direction).

The first wavelength conversion layer QD1, the second wavelength conversion layer QD2, and the transparent insulating film TINS may be disposed on the common electrode CE. The bottom surface and the side surfaces of the first wavelength conversion layer QD 1 may be in contact with the common electrode CE. The bottom surface and the side surfaces of the second wavelength conversion layer QD2 may be in contact with the common electrode CE. The bottom surface and the side surfaces of the transparent insulating film TINS may be in contact with the common electrode CE.

The first, second, and third LED elements LDC1, LDC2, and LDC3 may emit short-wavelength light such as blue light or UV light. The short-wavelength light may have a wavelength in a range of about 470 nm to about 460 nm, but embodiments of the disclosure are not limited thereto.

The first wavelength conversion layer QD1 may convert short-wavelength light into first light. The first light may be light of a red wavelength range. The red wavelength range may be in a range of about 600 nm to about 750 nm, but embodiments of the disclosure are not limited thereto.

The second wavelength conversion layer QD2 may convert short-wavelength light into second light. The second light may be light of a green wavelength range. The green wavelength range may be in a range of about 480 nm to about 560 nm, but embodiments of the disclosure are not limited thereto.

Each of the first and second wavelength conversion layers QD1 and QD2 may include a base resin, a wavelength shifter, and a scatterer.

The base resin may have high light transmittance and may be a material having an excellent dispersion characteristic for the wavelength shifter and the scatterer. For example, the base resin may include an organic material such as an epoxy resin, an acrylic resin, a cardo resin, or an imide resin.

The wavelength shifter may convert or shift the wavelength of incident light. The wavelength shifter may include quantum dots, quantum rods, or a phosphor. The quantum dot size of the first wavelength conversion layer QD 1 may differ from the quantum dot size of the second wavelength conversion layer QD2.

The scatterer may scatter incident light in random directions without substantially changing the wavelength of light passing through the first or second wavelength conversion layer QD1 or QD2. To this end, the path of light passing through the first or second wavelength conversion layer QD1 or QD2 can be increased, and as a result, the color conversion efficiency of the wavelength shifter can be improved. The scatterer may include light-scattering particles. For example, the scatterer may include particles of a metal oxide such as titanium oxide (TiO₂), silicon oxide (SiO₂), zirconium oxide (ZrO₂), aluminum oxide (Al₂O₃), indium oxide (In₂O₃), zinc oxide (ZnO), or tin oxide (SnO₂). As an example, the scatterer may include particles of an organic material such as an acrylic resin or a urethane resin.

The transparent insulating film TINS may transmit short-wavelength light (such as blue light or UV light) therethrough as it is. The transparent insulating film TINS may be formed as an organic film with high transmittance.

A first color filter CF1 may be disposed on the first wavelength conversion layer QD1. The first color filter CF1 may transmit first light (for example, red-wavelength light) therethrough. Thus, short-wavelength light that is emitted from the first LED element LDC1 and is not converted into first light may not be able to pass through the first color filter CF1. On the contrary, first light obtained by the first wavelength conversion layer QD1 may pass through the first color filter CF1.

A second color filter CF2 may be disposed on the second wavelength conversion layer QD2. The second color filter CF2 may transmit second light (for example, green-wavelength light) therethrough. Thus, short-wavelength light that is emitted from the second LED element LDC2 and is not converted into second light may not be able to pass through the second color filter CF2. On the contrary, second light obtained by the second wavelength conversion layer QD2 may pass through the second color filter CF2.

A third color filter CF3 may be disposed on the transparent insulating film TINS. The third color filter CF3 may transmit third light (for example, blue-wavelength light) therethrough. Thus, short-wavelength light emitted from the third LED element LDC3 may pass through the third color filter CF3.

A black matrix BM may be disposed on the common electrode CE. The black matrix BM may overlap the partition walls PT in the third direction (for example, Y-axis direction).

As illustrated in FIG. 6, as the partition walls PT may be formed to be higher than the LED elements LDC, the first and second wavelength conversion layers QD1 and QD2 may be disposed on the LED elements LDC, between the partition walls PT. Accordingly, the image quality of the display device of FIG. 6 can be improved.

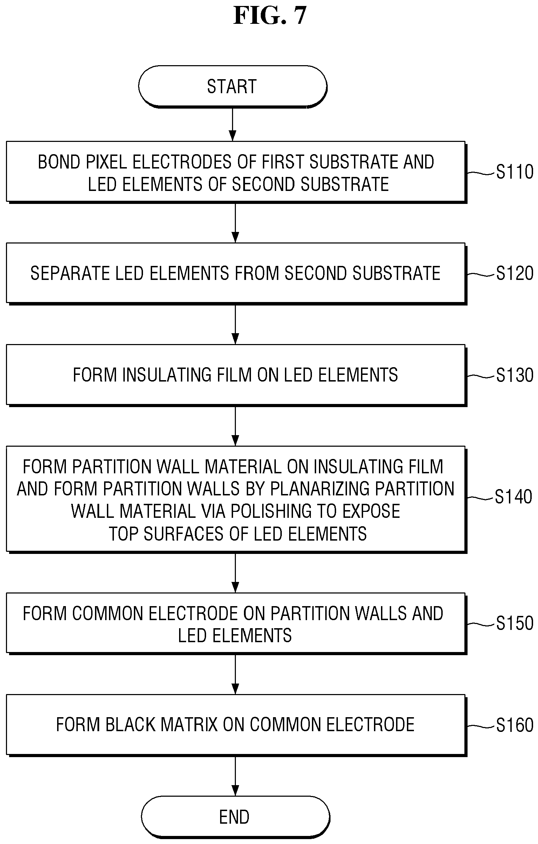

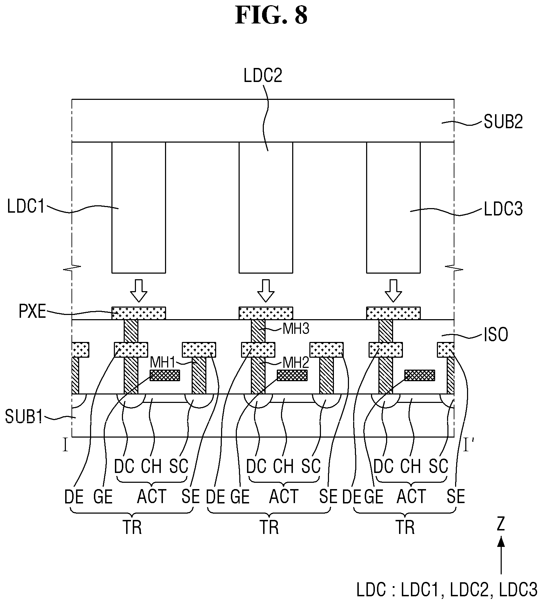

FIG. 7 is a flowchart illustrating a method of manufacturing a display device according to an embodiment. FIGS. 8 through 14 are schematic cross-sectional views illustrating the method of manufacturing a display device according to an embodiment. FIGS. 8 through 14 are schematic cross-sectional views taken along line I-I' of FIG. 2.

The method of manufacturing a display device according to an embodiment will hereinafter be described with reference to FIGS. 7 through 14.

Referring to FIGS. 7 and 8, pixel electrodes PXE of a first substrate SUB1 and LED elements LDC of a second substrate SUB2 are bonded (S110).

Pixel circuit units 110, which may include transistors TR and pixel electrodes PXE, may be formed on a first substrate SUB1. The first substrate SUB1 may be a p- or n-type silicon substrate.

The LED elements LDC may be vertical LED elements that extend in a third direction (or a Z-axis direction). The formation of the LED elements LDC will hereinafter be described.

The LED elements LDC may be formed by forming n-type electrodes NE on a substrate for monocrystalline growth and sequentially growing n-type GaN semiconductor layers NSEM, active layers MQW, and p-type GaN semiconductor layers PSEM on the n-type electrodes NE. The substrate for monocrystalline growth may be a sapphire substrate. The n-type GaN semiconductor layers NSEM, the active layers MQW, and the p-type GaN semiconductor layers PSEM may be formed by a deposition process such as metal-organic chemical vapor deposition (MOCVD), molecular beam epitaxy (MBE), or hydride vapor phase epitaxy (HVPE). P-type electrodes PE may be deposited on the p-type GaN semiconductor layers PSEM, and the growth for monocrystalline growth may be separated from the n-type GaN semiconductor layers NSEM by a laser lift-off (LLO) process.

The LED elements LDC, separated from the substrate for monocrystalline growth, may be transferred and bonded to a second substrate SUB2. The second substrate SUB2 may be formed of glass or plastic.

The LED elements LDC of the second substrate SUB2 may be bonded to the pixel electrodes PXE of the first substrate SUB 1. The LED elements LDC of the second substrate SUB2 may be bonded to the pixel electrodes PXE of the first substrate SUB 1 via a thermal compression process or a laser process.

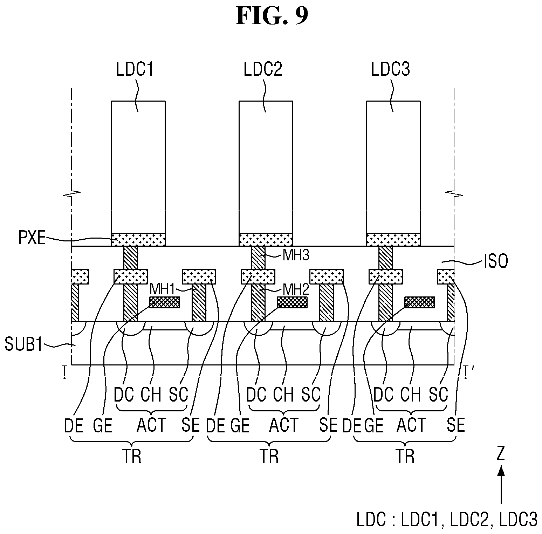

Thereafter, referring to FIGS. 7 and 9, the LED elements LDC may be separated from the second substrate SUB2 (S120).

To facilitate the separation of the second substrate SUB2 from the LED elements LDC, the adhesion between the LED elements LDC and the second substrate SUB2 may be weaker than the adhesion between the LED elements LDC and the pixel electrodes PXE. Also, the adhesion between the second substrate SUB2 and the LED elements LDC may be further weakened by laser, and the second substrate SUB2 may be separated from the LED elements LDC.

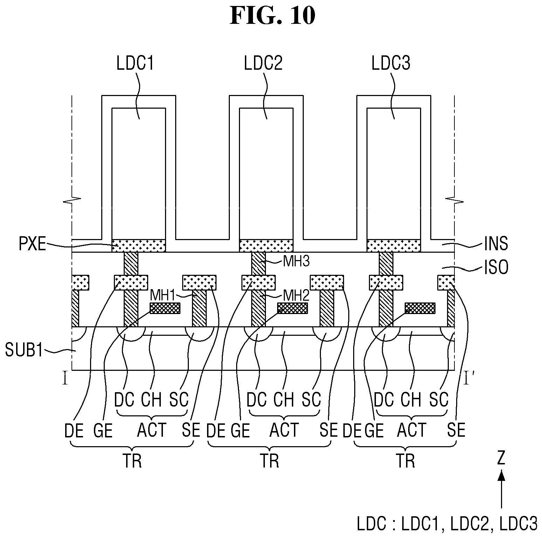

Thereafter, referring to FIGS. 7 and 10, an insulating film INS may be formed on the LED elements LDC (S130).

The insulating film INS may be deposited on the entire surface of a semiconductor circuit unit 110. Thus, the insulating film INS may be deposited on the LED elements LDC and on an insulating layer ISO. The insulating film INS may be formed on the side surfaces of a first LED element LDC1, the side surfaces of a second LED element LDC2, the side surfaces of a third LED element LDC3, and the side surfaces of each of the pixel electrodes PXE.

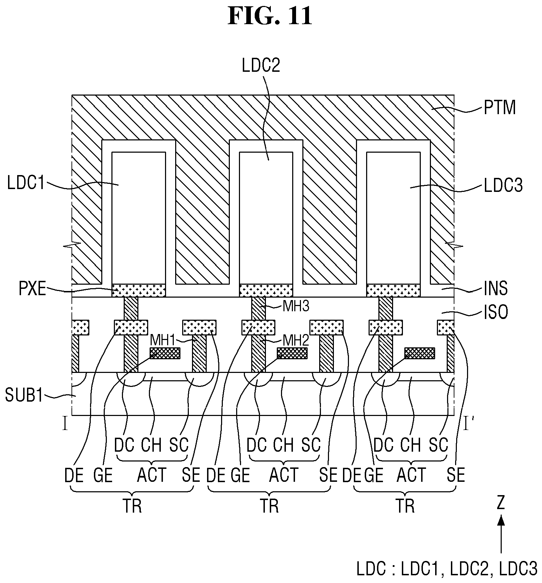

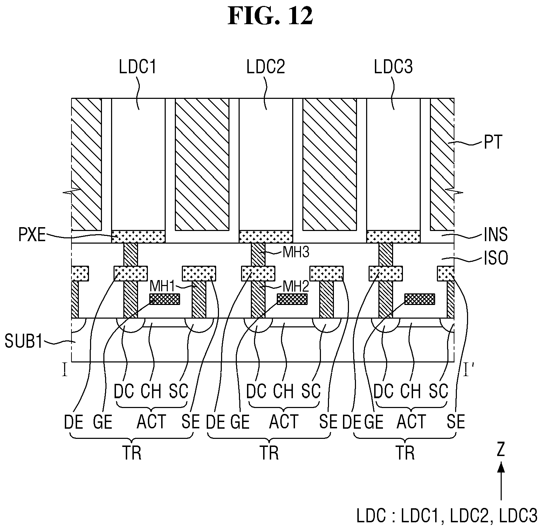

Thereafter, referring to FIG. 11, a partition wall material PTM may be formed on the insulating film INS. Thereafter, referring to FIGS. 7 and 12, partition walls PT may be formed (S140) by planarizing the partition wall material PTM via polishing to expose the top surfaces of the LED elements LDC.

The partition wall material PTM may be formed by electroplating. The height of the partition wall material PTM may be greater than the height of the LED elements LDC. Thus, the top surfaces of the LED elements LDC may be covered or overlapped by the partition wall material PTM.

The partition wall material PTM may be a conductive material or a photosensitive material blocking light. In case that the partition wall material PTM is a conductive material, the partition wall material PTM may include a metallic material with high reflectance. For example, the partition wall material PTM may include an opaque metallic material such as Mo, Al, Cr, Au, Ti, Ni, Nd, or Cu. In a case where the partition wall material PTM is a photosensitive material, the partition wall material PTM may include an inorganic black pigment such as carbon black or an organic black pigment.

Thereafter, the partition walls PT may be formed by removing the upper part of the partition wall material PTM via polishing such as CMP. As a result, the top surfaces of the LED elements LDC and the top surface of the insulating film INS may not be covered or overlapped, but may be exposed by the partition walls PT. Also, the top surfaces of the LED elements LDC, the top surface of the insulating film INS, and the top surfaces of the partition walls PT may be planarized.

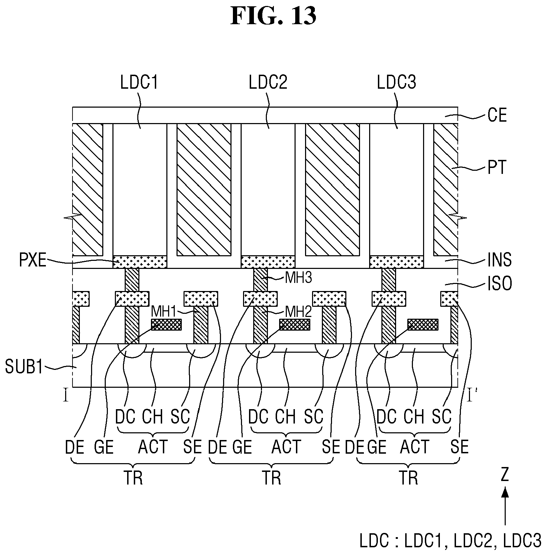

Thereafter, referring to FIGS. 7 and 13, a common electrode CE may be formed on the partition walls PT and the LED elements LDC (S150).

The common electrode CE may be deposited on the top surfaces of the LED elements LDC, the top surface of the insulating film INS, and the top surfaces of the partition walls PT. As the partition walls PT are not disposed in a common electrode connector CNT, the common electrode CE may be electrically connected to a common connecting electrode CBE through the common electrode connector CNT, which penetrates the insulating film INS. The common connecting electrode CBE may be disposed on the insulating layer ISO. The common electrode CE may include a TCO such as ITO or IZO.

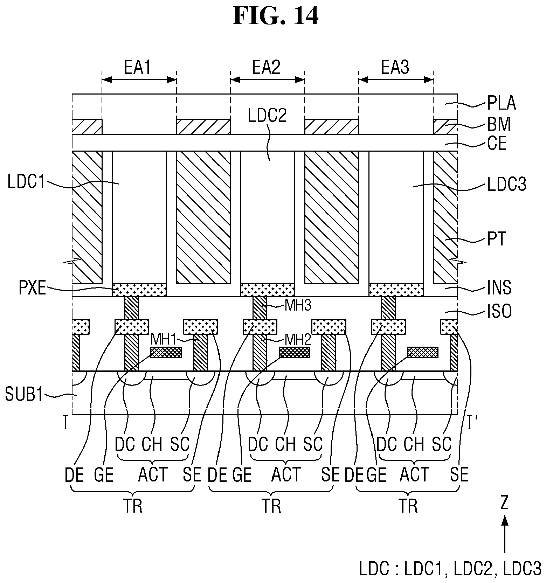

Thereafter, referring to FIGS. 7 and 14, a black matrix BM may be formed on the common electrode CE (S160).

The black matrix BM may be formed to overlap the partition walls PT in the third direction (for example, Z-axis direction) via photolithography. The black matrix BM may be formed of a photosensitive resin blocking light. For example, the black matrix BM may include an inorganic black pigment such as carbon black or an organic black pigment.

In a case where the partition walls PT may be formed of a photosensitive resin blocking light, the black matrix BM may not be provided.

A planarization film PLA may be formed by depositing an organic material on the common electrode CE and the black matrix BM. The planarization film PLA may be formed as an organic film including an acrylic resin, an epoxy resin, a phenolic resin, a polyamide resin, or a polyimide resin.

As illustrated in FIGS. 8 through 14, as the LED elements LDC are vertical LED elements that extend in the third direction (for example, Z-axis direction), the partition wall material PTM may be formed to fill the gaps between the LED elements LDC, and the top surfaces of the LED elements LDC may be exposed by polishing such as CMP. Thus, since the partition walls PT do not need to be thinned down by, for example, photolithography, the fabrication of the partition walls PT between the LED elements LDC can be facilitated.

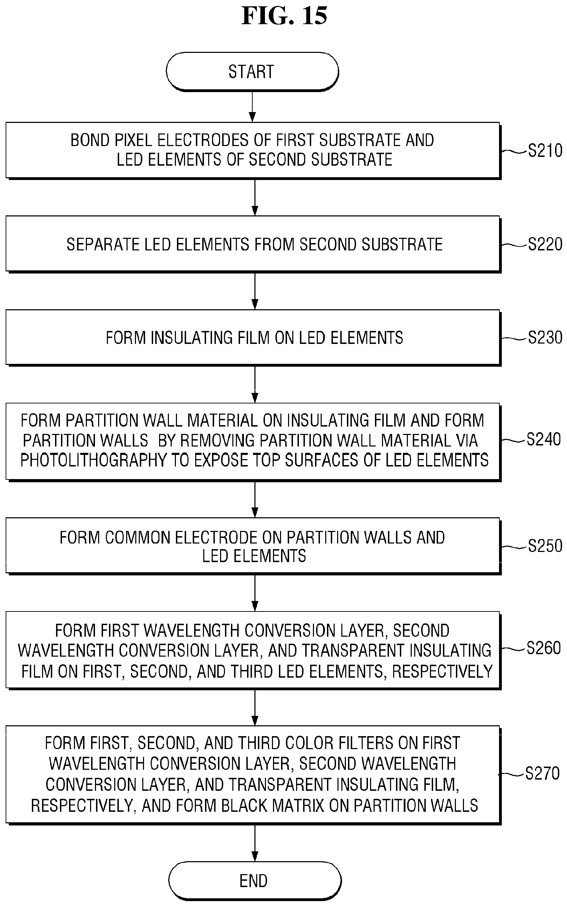

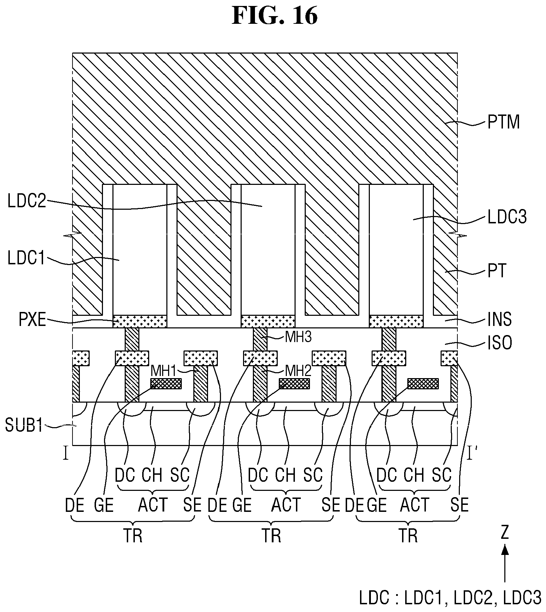

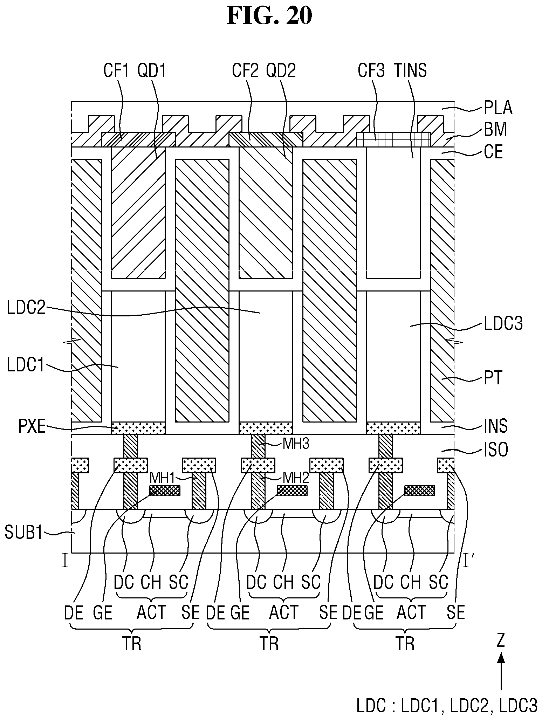

FIG. 15 is a flowchart illustrating a method of manufacturing a display device according to an embodiment. FIGS. 16 through 20 are schematic cross-sectional views illustrating the method of manufacturing a display device according to an embodiment. FIGS. 16 through 20 are schematic cross-sectional views taken along line I-I' of FIG. 2.

S210, S220, and S230 of FIG. 15 are substantially the same as S110, S120, and S130, respectively, of FIG. 7, and thus, detailed descriptions thereof will be omitted.

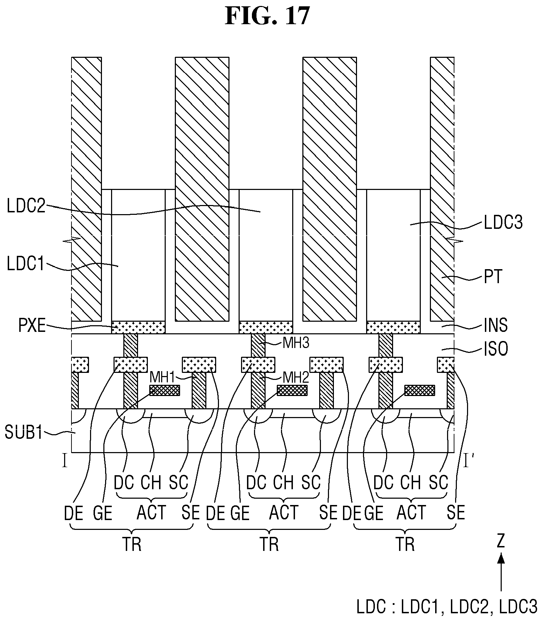

Referring to FIG. 16, a partition wall material PTM may be formed on an insulating film INS. Thereafter, referring to FIGS. 15 and 17, partition walls PT may be formed by etching the partition wall material PTM to expose the top surfaces of LED elements LDC (S240).

The partition wall material PTM may be formed by electroplating. The height of the partition wall material PTM may be greater than the height of the LED elements LDC. Thus, the top surfaces of the LED elements LDC may be covered or overlapped by the partition wall material PTM.

The partition wall material PTM may be a conductive material. For example, the partition wall material PTM may include an opaque metallic material such as Mo, Al, Cr, Au, Ti, Ni, Nd, or Cu.

Thereafter, the partition walls PT may be formed by removing part of the partition wall material PTM via photolithography. As a result, the top surfaces of the LED elements LDC and the top surface of the insulating film INS may not be covered or overlapped, but may be exposed by the partition walls PT. The height of the partition walls PT may be greater than the height of the LED elements LDC, and as a result, there may exist spaces on the LED elements LDC, between the partition walls PT. The spaces may have a substantially hole-like shape.

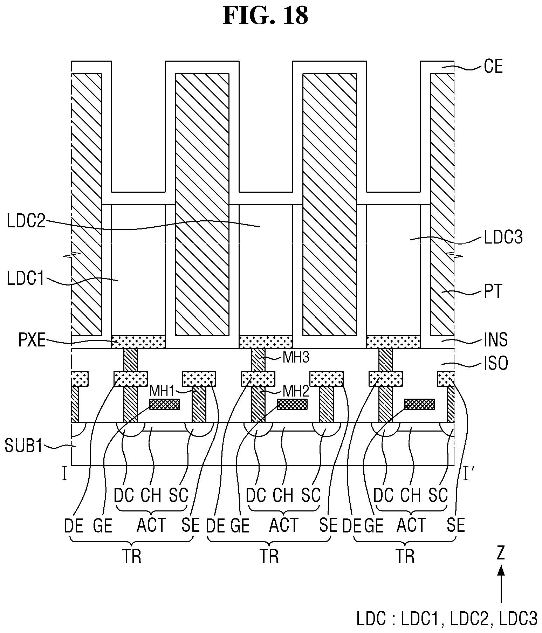

Thereafter, referring to FIGS. 15 and 18, a common electrode CE may be formed on the partition walls PT and the LED elements LDC (S250).

The common electrode CE may be deposited on the top surfaces of the LED elements LDC, the top surface of the insulating film INS, the top surfaces of the partition walls PT, and parts of the side surfaces of the partition walls PT. As the partition walls PT are higher than the LED elements LDC, the common electrode CE may be disposed on the side surfaces of parts of the partition walls PT that protrude beyond the LED elements LDC.

The common electrode CE may be electrically connected to a common connecting electrode CBE via a common electrode connector CNT, which penetrates the insulating film INS and the partition walls PT. The common connecting electrode CBE may be disposed on an insulating layer ISO. The common electrode CE may include a TCO such as ITO or IZO.

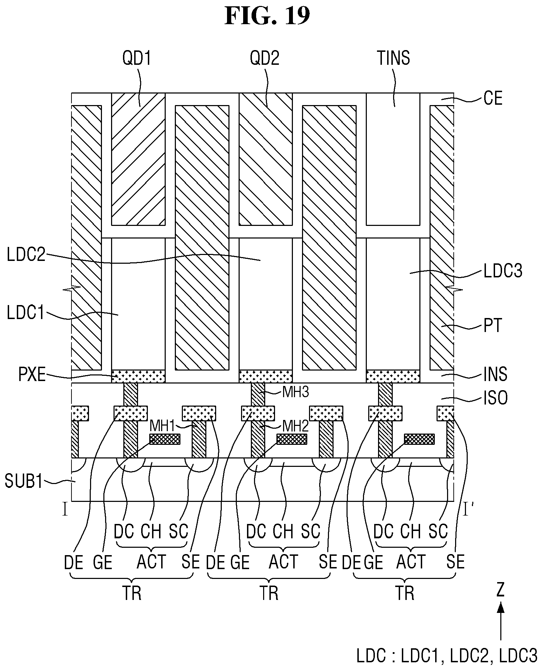

Thereafter, referring to FIGS. 15 and 19, a first wavelength conversion layer QD1, a second wavelength conversion layer QD2, and a transparent insulating film TINS may be formed on first, second, and third LED elements LDC1, LDC2, and LDC3, respectively (S260).

The first wavelength conversion layer QD1, the second wavelength conversion layer QD2, and the transparent insulating film TINS may be disposed on the common electrode CE. The bottom surface and the side surfaces of the first wavelength conversion layer QD1 may be in contact with the common electrode CE. The bottom surface and the side surfaces of the second wavelength conversion layer QD1 may be in contact with the common electrode CE. The bottom surface and the side surfaces of the transparent insulating film TINS may be in contact with the common electrode CE.

Each of the first and second wavelength conversion layers QD1 and QD2 may include a base resin, a wavelength shifter, and a scatterer. The transparent insulating film TINS may be formed as an organic film with high transmittance.

The first wavelength conversion layer QD1 may overlap the first LED element LDC1 in a third direction (or a Z-axis direction). The second wavelength conversion layer QD2 may overlap the second LED element LDC2 in the third direction (for example, Z-axis direction). The transparent insulating film TINS may overlap the third LED element DC3 in the third direction (for example, Z-axis direction).

Thereafter, referring to FIG. 15, first, second, and third color filters CF1, CF2, and CF3 may be formed on the first wavelength conversion layer QD1, the second wavelength conversion layer QD2, and the transparent insulating film TINS, respectively, and a black matrix BM may be formed on the partition walls PT (S270).

The first color filter CF1 may be formed on the first wavelength conversion layer QD1 via photolithography. The first color filter CF1 may be a red filter transmitting first light (for example, red-wavelength light) therethrough.

The second color filter CF2 may be formed on the second wavelength conversion layer QD2 via photolithography. The second color filter CF2 may be a green filter transmitting second light (for example, green-wavelength light) therethrough.

The third color filter CF3 may be formed on the transparent insulating film TINS via photolithography. The third color filter CF3 may be a blue filter transmitting third light (for example, blue-wavelength light) therethrough.

The black matrix BM may be formed on the partition walls PT via photolithography. The black matrix BM may be formed of a photosensitive resin blocking light. For example, the black matrix BM may include an inorganic black pigment such as carbon black or an organic black pigment.

A planarization film PLA may be formed by depositing an organic material on the common electrode CE and the black matrix BM. The planarization film PLA may be formed as an organic film including an acrylic resin, an epoxy resin, a phenolic resin, a polyamide resin, or a polyimide resin.

As illustrated in FIGS. 15 through 20, first and second wavelength conversion layers QD1 and QD2 may be provided or disposed in the spaces on the LED elements LDC, between the partition walls PT, by forming the partition walls PT to be higher than the LED elements LDC. Accordingly, the image quality of a display device can be improved.

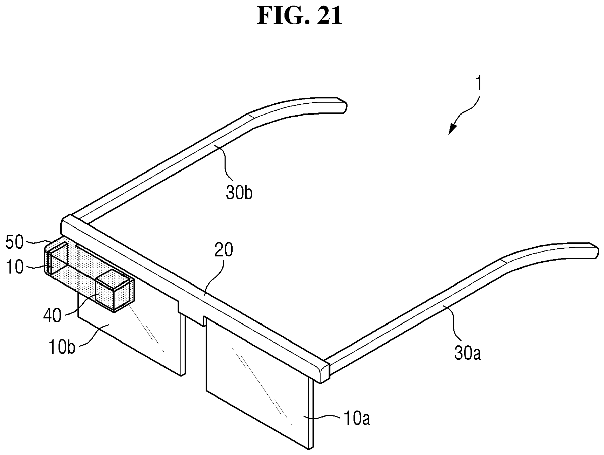

FIG. 21 is a perspective view of a virtual reality (VR) device including a display device according to an embodiment. FIG. 21 illustrates a VR device 1 to which a display device 10 according to an embodiment is applied.

Referring to FIG. 21, the VR device 1 may be a glasses-type device. The VR device 1 may include the display device 10, a left-eye lens 10a, a right-eye lens 10b, a supporting frame 20, first and second glasses temples 30a and 30b, a reflective member 40, and a display device storage 50.

FIG. 21 illustrates a glasses-type VR device 1 including the first and second glasses temples 30a and 30b, as an example, the VR device 1 may also be applicable to a head-mounted display (HMD) including a head band. For example, the VR device 1 of embodiments is not limited to the embodiment of FIG. 21, but may also be applicable to various electronic devices.

The supporting frame 20 supports the left- and eye-lenses 10a and 10b. The supporting frame 20 may be disposed on the top surfaces of the left- and right-eye lenses 10a and 10b. The supporting frame 20 may be formed to extend in the widthwise direction (or an X-axis direction) of the left- and eye-lenses 10a and 10b.

The first glasses temple 30a may be fixed to the left end of the supporting frame 20. The second glasses temple 30b may be fixed to the right end of the supporting frame 20.

The first and second glasses temples 30a and 30b may be fixed to the supporting frame 20 via fixing members such as screws. As an example, the supporting frame 20, the first glasses temple 30a, and the second glasses temple 30b may be formed in one body. The supporting frame 20, the first glasses temple 30a, and the second glasses temple 30b may include plastic, a metal, or both.

The left- and right-eye lenses 10a and 10b may be formed of glass or plastic to be transparent or semitransparent. As a result, a user can view a real-world image through the left- or right-eye lenses 10a and 10b. The left- and right-eye lenses 10a and 10b may have refractive power in consideration of the user's vision.

The left- and right-eye lenses 10a and 10b may be formed as hexahedrons consisting of six rectangular planes. The left-eye lens 10a may be disposed to face the left eye of the user, and the right-eye lens 10b may be disposed to face the right eye of the user. The left- and right-eye lenses 10a and 10b are not limited to the embodiment of FIG. 21. As an example, the left- and right-eye lenses 10a and 10b may be formed as polyhedrons consisting of polygonal planes other than rectangular planes. As an example, the left- and right-eye lenses 10a and 10b may be formed as cylinders, elliptical cylinders, semicircular cylinders, semielliptical cylinders, distorted cylinders, or distorted semicircular cylinders. Here, the distorted cylinders or the distorted semicircular cylinders refer to cylinders or semicircular cylinders with an irregular diameter.

The display device storage 50 may be disposed at the right end of the supporting frame 20. The display device storage 50 may be disposed at the front of the supporting frame 20. The display device 10 and the reflective member 40 may be stored in the display device storage 50.

An image displayed by the display device 10 may be reflected by the reflective member 40 and may thus be provided to the right eye of the user through the right-eye lenes 10b. As a result, the user may view a VR image from the display device 10 with his or her right eye.

FIG. 21 illustrates that the display device storage 50 is disposed at the right end of the supporting frame 20, but embodiments of the disclosure are not limited thereto. As an example, the display device storage 50 may be disposed at the left end of the supporting frame 20, in which case, the image displayed by the display device 10 may be reflected by the reflective member 40 and may thus be provided to the left eye of the user through the left-eye lens 10a. As a result, the user may view the VR image from the display device 10 with his or her left eye. As an example, the display device storage 50 may be disposed at both the left and right ends of the supporting frame 20, in which case, the user may view the VR image from the display device 10 with his or her both eyes.

As discussed, embodiments can provide a display device comprising: pixel electrodes disposed on a substrate; light-emitting diode elements disposed on the pixel electrodes; an insulating film disposed on at least a side of each of the pixel electrodes and disposed on at least a side of each of the light-emitting diode elements; partition walls disposed on the insulating film; and a common electrode disposed on the partition walls and the light-emitting diode elements.

The insulating film may contact at least a side of each of the pixel electrodes and may contact a side of each of the light-emitting diode elements.

Each pixel electrode may be connected to a transistor, and each transistor may include an active layer, a gate electrode, a source electrode, and a drain electrode. An insulating layer may be disposed on the substrate. The gate electrode, source electrode, and drain electrodes may be disposed in the insulating layer. The pixel electrodes may be disposed on the insulating layer.

The light-emitting diode elements may be vertical LED elements that extend in a direction away from the substrate. For example, the LED elements may extend longer in a direction away from the substrate than in a direction in the plane of the substrate. The LED elements may be mLED elements. The insulating film may be disposed on side surfaces of the vertical LED elements. The partition walls may contact the insulating film between the vertical LED elements.

The LED elements may be formed over the pixel electrode, with the pixel electrode having a corresponding planar area to the planar area of the LED elements.

The insulating film may be formed as an inorganic film such as a silicon nitride layer, a silicon oxynitride layer, a silicon oxide layer, a titanium oxide layer, or an aluminum oxide layer. As an example, the insulating film INS may be formed as an organic film including an acrylic resin, an epoxy resin, a phenolic resin, a polyamide resin, or a polyimide resin

While embodiments are described above, it is not intended that these embodiments describe all possible forms thereof. Rather, the words used in the specification are words of description rather than limitation, and it is understood that various changes may be made without departing from the spirit and scope of the of the disclosure. The features of various embodiments may be combined to form further embodiments.

## Claims

1. A display device comprising:
pixel electrodes disposed over a substrate;
light-emitting diode elements disposed over the pixel electrodes;
an insulating film disposed on at least a side of each of the pixel electrodes and disposed on at least a side of each of the light-emitting diode elements;
partition walls disposed on the insulating film; and
a common electrode disposed on the partition walls and the light-emitting diode elements.

2. The display device of claim 1, wherein the insulating film contacts the side of each of the pixel electrodes and contacts the side of each of the light-emitting diode elements.

3. The display device of claim 1 or 2, wherein the light-emitting diode elements extend longer in a direction away from the substrate than in a direction in the plane of the substrate.

4. The display device of any one of claims 1 to 3, wherein each of the light-emitting diode elements includes a first electrode, a light-emitting layer, and a second electrode, which are sequentially stacked in a thickness direction of the substrate wherein
the first electrode of each of the light-emitting diode elements electrically contacts one of the pixel electrodes, and
the second electrode of each of the light-emitting diode elements electrically contacts the common electrode.

5. The display device of any one of claims 1 to 4, wherein the partition walls include a conductive material, and the partition walls are electrically connected to the common electrode.

6. The display device of any one of claims 1 to 5, wherein the partition walls include an opaque metallic material.

7. The display device of any one of claims 1 to 5, wherein the partition walls include a photosensitive light blocking resin.

8. The display device of any one of claims 1 to 7, wherein a height of a partition wall of the partition walls is greater than a height of a light-emitting diode element of the light-emitting diode elements.

9. The display device of claim 8, wherein the common electrode is disposed on at least a side surface of each of the partition walls.

10. The display device of any one of claims 1 to 9, further comprising:
a first wavelength conversion layer overlapping a light-emitting diode element among the light-emitting diode elements in a first emission area in a thickness direction of the substrate;
a second wavelength conversion layer overlapping a light-emitting diode element among the light-emitting diode elements in a second emission area in the thickness direction of the substrate; and
a transparent insulating film overlapping a light-emitting diode element among the light-emitting diode elements in a third emission area in the thickness direction of the substrate, wherein the first wavelength conversion layer, the second wavelength conversion layer, and the transparent insulating film are disposed between the partition walls.

11. The display device of any one of claims 1 to 10, wherein
the common electrode is electrically connected to a common connecting electrode, and the common connecting electrode is disposed on the substrate through a common electrode connector through the insulating film.

12. A method of manufacturing a display device, comprising:
bonding pixel electrodes of a first substrate and light-emitting diode elements of a second substrate;
separating the light-emitting diode elements from the second substrate;
forming an insulating film on the light-emitting diode elements;
forming a partition wall material on the insulating film;
forming partition walls by planarizing the partition wall material by polishing to expose first electrodes of the light-emitting diode elements; and
forming a common electrode on the partition walls and the light-emitting diode elements.
